# EUROPEAN PATENT SPECIFICATION

(11) **EP 2 053 667 B1**
(45) Date of publication and mention of the grant of the patent: **22.06.2016**
(21) Application number: 08167507.6
(22) Date of filing: 24.10.2008
(51) Int. Cl.: H01L 33/48, H01L 33/60, H01L 33/62

(54) **Package structure of light emitting diode device and fabricating method thereof**
Baugruppe mit einer Leuchtdioden-Vorrichtung und Herstellungsverfahren dafür
Structure du boîtier d'un dispositif à diode électroluminescente et son procédé de fabrication

(30) Priority: 24.10.2007 TW 96139780
(43) Date of publication of application: 29.04.2009
(73) Proprietor: Advanced Optoelectronic Technology Inc., Hsinchu County 303 (TW)
(72) Inventor: Tseng, Wen Liang, 300, Hsinchu City (TW); Chen, Lung Hsin, 305, Hsinchu Country (TW); Tsang, Jian Shihn, 247, Lujhou City, Taipei Country (TW)
(74) Representative: Huang, Chongguang

(56) References cited:
- EP-A1- 0 221 616
- EP-A2- 1 835 550
- JP-A- 2006 135 276
- JP-A- 2006 278 666
- US-A1- 2006 138 436
- US-A1- 2007 018 190

## Description

### BACKGROUND OF THE INVENTION

### FIELD OF THE INVENTION

The present invention relates to a package structure for light emitting diode (LED) devices and a method of fabricating the same, and more particularly to a packaging and a fabricating method for a light emitting diode (LED) utilizing a silicon substrate.

### DESCRIPTION OF THE RELATED ART

Among varieties of optoelectronic devices, LEDs are anticipated as the optimum light sources of the future for their compact size, high illuminating efficiency and longevity. In addition, due to the development of liquid crystal displays (LCD) and full color displays, white LEDs are now applied in consumer electronics products such as cell phones and personal digital assistants (PDA) as well as the traditional applications such as indication lamps and billboard displays.

Presently, research and development of LEDs is focused on improving the light extraction efficiency and resolving the heat dissipation problem. For the light extraction efficiency, the epitaxy process, the chip process and the packaging process can all be improved to enhance LED performance. The heat dissipation problem will mainly be solved by improving the packaging process, as advances are made in both the package structure and the package material.

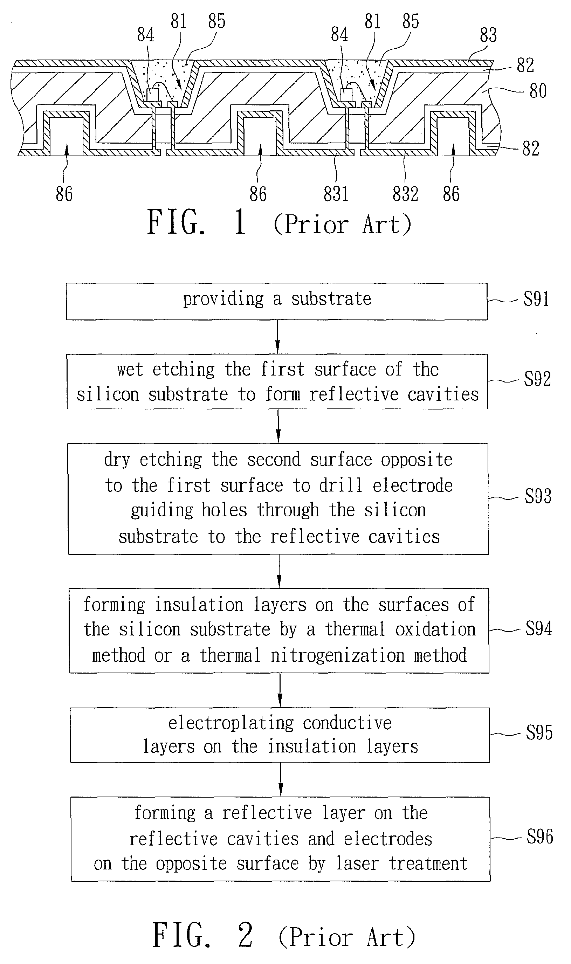

For example, the light extraction efficiency of the reflective cup packaging type, one of several packaging types for LEDs, can be enhanced by increasing the light reflection rate. Furthermore, suitably modified designs of the reflective cup can also improve the heat dissipation efficiency. U.S. patent No. 6,562,643 put forth such a modified design, and U.S. patent No. 6,268,660 and U.S. patent publication No. 2004/0218390 have the same objectives. U.S. Patent Application Publication No. 2007/018190 A1 discloses at least one groove filled with carbon nanotube material formed on an underside surface of a substrate to package an LED chip; therefore an LED package using this substrate is capable of effectively releasing heat emitted from the LED chip out of the LED package. EP Patent Pub. No. 1835550 A2 discloses a silicon substrate applied to a package structure of a solid-state lighting device wherein wet etching is performed to process top and bottom surfaces of the silicon substrate to form reflecting cavity and electrode access holes. JP. Patent Pub. No. 2006135276 A discloses a light emitting element mounting package which includes a silicon substrate and a reflector substrate laminated on the silicon substrate. In the silicon substrate a groove surrounding a mounting region is formed on the surface, and reflecting film is form in the inner surface of the groove to effectively lead out a light to the outside of the package. Moreover, U.S. patent No. 6,531,328 discloses that a silicon substrate 80 substitutes for a package substrate. Several reflective cups 81 are formed on the silicon substrate 80 by MEMS (micro electromechanical system) processes, as shown in FIG. 1. An insulation layer 82 and a metal layer 83 sequentially enclose the silicon substrate 80, and electrodes 831 and 832 are formed adjacent to the metal layer 80. Attached to the interior of each reflective cup 81 is an LED die 84, wherein the LED die 84 is electrically connected to the corresponding reflective cup 81 by bonding wires. An epoxy resin 85 encapsulates and therefore protects the LED die 84 in the corresponding reflective cup 81. There are two partial-depth holes 86 on each side of each reflective cup 81. The purpose of the two partial-depth holes, however, is not mentioned in U.S. patent No. 6,531,328 .

FIG. 2 is a flow chart of the manufacturing process of the device in FIG. 1. As shown in Step S91, the silicon substrate 80 is first provided for these steps. Subsequently, a plurality of reflective cavities is formed on the first surface of the silicon substrate 80 by wet etching, as shown in Step S92. Referring to Step S93, electrode guiding holes are formed on the second surface opposite to the first surface by dry etching. Insulation layers are deposited on the surfaces of the silicon substrate 80 by a thermal oxidation method or a thermal nitrogenization method, as shown in Step S94. The insulation layers can be made of SiO2 or Si3N4. Subsequently, conductive layers are deposited on the insulation layers by electroplating, as shown in Step S95. Finally, a reflective layer is formed on the reflective cavities, and the electrodes 831 and 832 are arranged on the opposite surface by laser treatment, as shown in Step S96.

The aforesaid structure of the LEDs on the silicon substrate has several shortcomings. First, the reflective layer and the electrodes are made of the same material. There is currently no metal simultaneously suitable for optimizing both reflectivity and solderability. Furthermore, due to the fact that various LEDs emit light with different wavelengths, and that reflective efficiency of the metal is directly related to the emitting wavelengths, the optimal material for the electrodes varies accordingly. Solder is preferable for the material of the electrodes, but is not a suitable material for reflecting visual light. Au, Ag, Pd and Pt are better reflective materials, but none of these is suitable as material of electrodes.

In addition, the formation of the lowermost guiding holes adapts the dry etching technique, wherein the etched pattern has less adaptability in subsequent processes. Moreover, the metal layer needs laser treatment to form reflective surfaces, resulting in higher manufacturing costs.

In a Taiwanese R.O.C. patent publication (publication No. 200834970), the Applicant solved most of the problems of the aforesaid prior art. However, the resistivity of the silicon substrate adapted in R.O.C. patent publication No. 200834970 is required to be over 800Ω -cm. Otherwise, the solder may flow from the electrodes to the lateral surface of the silicon substrate and cause a short circuit. The manufacturing cost of high resistivity silicon substrate, however, is much higher than that of the low resistivity silicon substrate and is therefore the main drawback of the R.O.C. patent publication.

Consequently, there is a need in the optoelectronic market for high power LED devices or LED technology that is reliable and exhibits a simple structure that solves the aforesaid problems.

### SUMMARY OF THE INVENTION

The present invention, defined in the appended claims, provides a package structure for LED devices and a method of fabricating the same. A silicon substrate is used as the package substrate to enhance heat dissipation efficiency. Furthermore, MEMS processes can be effectively applied to the substrate.

The present invention also provides a package structure for LED devices and a method of fabricating the same, wherein a recess part is disposed on the external side of the electrode of each LED device. An insulating layer encloses the recess part such that the solder cannot flow from the electrode to the lateral surface of the silicon substrate, and short circuit is thus prevented.

The present invention also provides a low cost package structure for LED devices and a method of fabricating the same, which adapts low cost silicon substrate with low resistivity for the package structure such that the manufacturing cost is greatly reduced.

The present invention allows the usage of different materials for the reflective layer and electrodes. The material of the reflective layer is selected based on the requirement to reflect light of specific wavelengths without affecting the choice of electrode material. Therefore, optimal materials are respectively selected for the reflective layer and the electrodes.

The present invention may adapt wet etching technique to form electrodes via holes at the bottom of the device to leave more space for subsequent process windows.

The present invention also provides an insulating layer to protect the metal in the reflective layer from oxidation, vulcanization, or reaction with other chemical substances. The thickness of the insulating layer could be adjusted to produce constructive interference of specific rays.

A package structure for photoelectronic devices according to one embodiment of the present invention comprises a silicon substrate, a first insulating layer, a reflective layer, a second insulating layer, a first conductive layer, a second conductive layer and a die. The silicon substrate has a first surface and a second surface, wherein the first surface is opposed to the second surface. A a reflective opening is defined in the first surface, and the second surface has at least two electrode via holes connected to the reflective opening and a recess located outside each of the electrode via holes. The first insulating layer overlays the first surface, the second surface and the recesses. The reflective layer is disposed on the reflective opening. The second insulating layer is disposed on the reflective layer. The first conductive layer is disposed on the surface of the second insulating layer. The second conductive layer is located outside the at least one recess and disposed on the surface of the second surface and inside the electrode via holes. The die is fixed inside the reflective opening and electrically connected to the first conductive layer.

Preferably, the first insulating layer is made of silicon oxide, and the second insulating layer is made of silicon dioxide, silicon nitride or silicon oxynitride.

Preferably, the reflective layer is made of aluminum (Al), silver (Ag), gold (Au), tin (Sn), copper (Cu) or platinum (Pt), and the thickness thereof is between 300 angstroms and 20,000 angstroms.

Preferably, the first conductive layer is extended to and connected with the second conductive layer, wherein the first conductive layer and the second conductive layer are made of a solderable material, such as silver (Ag), nickel/gold (Ni/Au), titanium/gold (Ti/Au), titanium/nickel/gold (Ti/Ni/Au), titanium/copper/nickel/gold (Ti/Cu/Ni/Au), titanium/tungsten/copper/nickel/gold (TiW/Cu/Ni/Au) or chromium/ copper/nickel/gold (Cr/ Cu/Ni/Au).

The package structure of this embodiment of the present invention further comprises an encapsulating layer filled in the reflective opening.

Preferably, the die is electrically connected to the first conductive layer via a plurality of bumps.

A package structure for photoelectronic devices according to another embodiment of the present invention comprises a silicon substrate, a first insulating layer, a metal layer, a second insulating layer, an electrode layer and a die. The silicon substrate has a first surface and a second surface, wherein the first surface is opposed to the second surface, a reflective opening is defined in the first surface, the second surface has a plurality of electrode via holes connected to the reflective opening, and at least one recess formed on the second surface is located outside each of the electrode via holes. The first insulating layer overlays the first surface, the second surface and the recesses. The metal layer is disposed inside the reflective opening, comprising a reflective area and a conductive area. The second insulating layer is disposed on the reflective area. The electrode layer is disposed on the surface of the first insulating layer and inside the electrode via holes. The die is fixed inside the reflective opening and electrically connected to the conductive area of the metal layer.

Preferably, the reflective area is made of aluminum (Al), silver (Ag), gold (Au), tin (Sn), copper (Cu) or platinum (Pt).

Preferably, the electrode layer is connected to the conductive area of the metal layer, wherein the electrode layer and the metal layer are made of a solderable material, such as silver (Ag), nickel/gold (Ni/Au), titanium/gold (Ti/Au), titanium/nickel/gold (Ti/Ni/Au), titanium/copper/ nickel/gold (Ti/Cu/Ni/Au), titanium/tungsten/copper/nickel/ gold (TiW/Cu/Ni/Au) or chromium/ copper/nickel/gold (Cr/ Cu/Ni/Au).

A fabrication method of a package structure for LED devices according to another embodiment of the present invention comprises the steps of: providing a silicon substrate; forming at least one reflective opening in a first surface of the silicon substrate extending inwards the first surface; forming a plurality of electrode via holes and recesses on a second surface of the silicon substrate, wherein the electrode via holes penetrate through the silicon substrate to reach the at least one reflective opening, and the recesses are located outside the electrode via holes; forming a first insulating layer overlaying the at least one reflective opening, the plurality of electrode via holes and recesses; forming a reflective layer inside the at least one reflective opening; forming a second insulating layer on the reflective layer; forming a first conductive layer on the second insulating layer; forming a second conductive layer on the second surface of the silicon substrate and inside the electrode via holes wherein the second conductive layer is located outside the recesses; and fixing a die inside the reflective opening and electrically connecting the die with the first conductive layer.

Preferably, the first insulating layer is made of silicon oxide formed by a hot oxidation process, and the second insulating layer is made of silicon dioxide, silicon nitride or silicon oxynitride deposited by vapor deposition process.

Preferably, the first conductive layer and the second conductive layer are formed by electroplating, evaporating or chemical plating techniques, and the first conductive layer is connected to the second conductive layer.

Preferably, the die is fixed inside the reflective opening by flip-chip or wire bonding technique.

Preferably, the fabrication method of this embodiment further comprises the step of filling an encapsulating layer inside the reflective opening and the electrode via holes.

A fabrication method of a package structure for LED devices according to another embodiment of the present invention comprises the steps of: providing a silicon substrate; forming at least one reflective opening on a first surface of the silicon substrate; forming a plurality of electrode via holes and recesses on a second surface of the silicon substrate, wherein the electrode via holes penetrate through the silicon substrate to reach the at least one reflective opening, and the recesses are located outside the electrode via holes; forming a first insulating layer overlaying the at least one reflective opening, the plurality of electrode via holes and recesses; forming a metal layer inside the at least one reflective opening, wherein the metal layer comprises a reflective area and a conductive area; forming a second insulating layer at the reflective area; forming an electrode layer on the second surface of the silicon substrate and inside the electrode via holes; and fixing a die inside the reflective opening and electrically connecting the die with the first conductive area.

Preferably, the metal layer and the electrode layer are formed by electroplating, evaporating or chemical plating techniques.

A package structure for LED devices according to another embodiment of the present invention comprises a silicon substrate, a first insulating layer, a reflective layer, a second insulating layer, a first conductive layer and a second conductive layer. The silicon substrate has a first surface and a second surface opposite to each other, wherein the first surface has a reflective opening thereon, the second surface has at least two electrode via holes thereon connected to the reflective opening, and the second surface also has at least one recess located outside each of the electrode via holes. The first insulating layer overlays the first surface, the second surface and the recess. The reflective layer is disposed on the reflective opening. The second insulating layer is disposed on the reflective layer. The first conductive layer is disposed on the at least two electrode via holes, wherein the first conductive layer serves as two electrode pads and is electrically isolated from the reflective layer. The second conductive layer is disposed beneath the second surface and inside the at least two electrode via holes.

Preferably, the first conductive layer and the second conductive layer are made of a solderable material, wherein the first conductive layer is electrically connected to the second conductive layer.

Preferably, the first conductive layer and the second conductive layer are formed by pattern transfer etching or lift-off process.

### BRIEF DESCRIPTION OF THE DRAWINGS

The invention will be described according to the appended drawings in which:
FIG. 1 is a diagram showing a conventional package structure for an LED;
FIG. 2 is a flow chart for fabricating the package structure in FIG. 1;
FIG. 3A to 3N show the flow chart of an embodiment of the manufacturing method for photoelectronic devices of the present invention;
FIG. 4A to 4C show the flow chart of another embodiment of the manufacturing method for photoelectronic devices of the present invention;
FIG. 5 shows an alternative example of a package structure for an LED;
FIG. 6 shows another example of a package structure for an LED;
FIG. 7A to 7I show the flow chart of another embodiment of the manufacturing method for photoelectronic devices of the present invention; and
FIG. 8 shows the diagram of another embodiment of the package structure of the present invention.

### PREFERRED EMBODIMENT OF THE PRESENT INVENTION

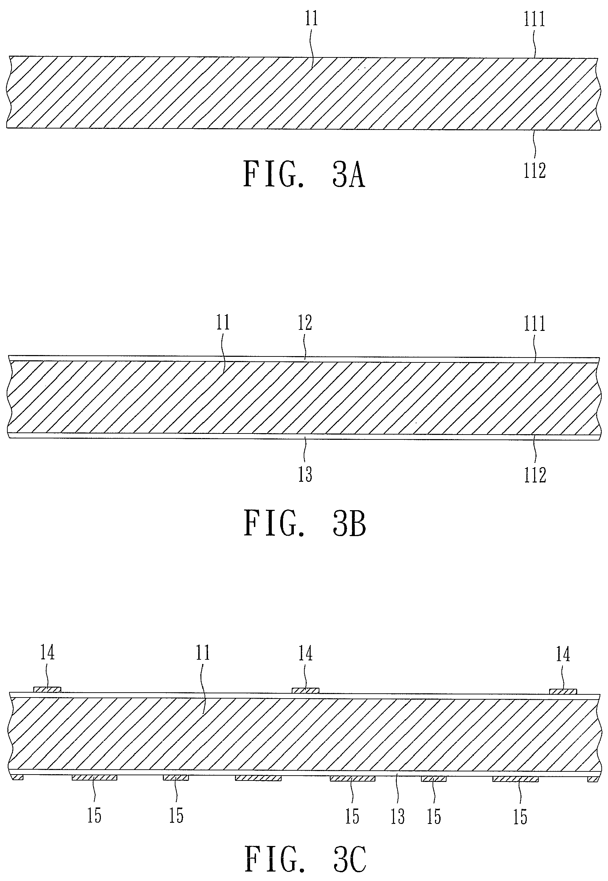

FIG. 3A to 3O show the flow chart of an embodiment of the manufacturing method for LED devices of the present invention. As shown in FIG. 3A, a silicon substrate 11 is provided, which comprises a first surface 111 and a second surface 112, wherein the first surface 111 is the upper surface and the second surface 112 is the lower surface. The silicon substrate 11 can be a 5-inch, 6-inch, 8-inch or 12-inch silicon wafer with low resistivity (< 200Ω -cm). The silicon substrate 11 may adapt a <100> crystal orientation surface. The silicon atoms can be categorized as single crystal silicon, polysilicon and amorphous silicon according to the crystallization process. A few important advantages offered by the silicon substrate 11 are its great heat dissipation capability and its suitability for well-developed semiconductor process or MEMS process.

As shown in FIG. 3B, the silicon substrate 11 is then covered by dielectric layers 12 and 13 (or an insulating layer). The step shown in FIG. 3B can be accomplished by deposition process with plasma-enhanced chemical vapor deposition (PECVD) technique. The material of the dielectric layers 12 and 13 is selected such that it can be etched by an anti-silicon anisotropic etchant. The selection of the anti-silicon anisotropic etchant can be potassium (KOH), tetramethyl ammonium hydroxide (TMAH), ethylenediamine pyrocatochol (EDP) or N2H4. The material of the dielectric layers 12 and 13 can be silicon nitride (Si3N4), silicon dioxide or silicon oxynitride. In this embodiment, the dielectric layers 12 and 13 are made of silicon nitride. As shown in FIG. 3C, the dielectric layers 12 and 13 are then respectively covered by patterned photoresist layers 14 and 15.

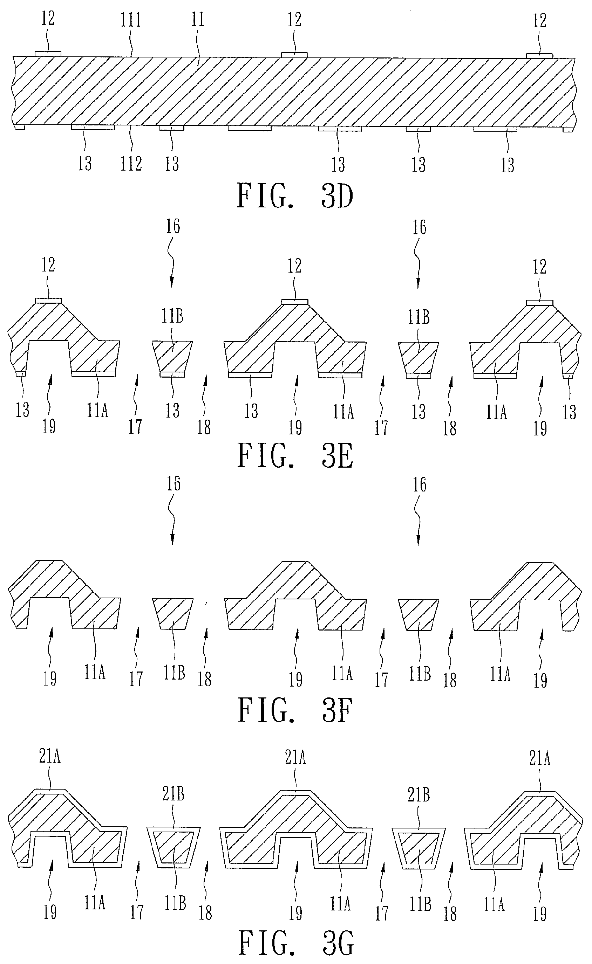

As shown in FIG. 3D, the portion of the dielectric layers 12 and 13 not covered under the photoresist layers 14 and 15 is then removed by etching. The photoresist layers 14 and 15 are subsequently removed also. As shown in FIG. 3E, the portion of the first surface 111 not covered under the dielectric layer 12 is etched away to form a plurality of reflective openings 16 and recesses 19. Likewise, the portion of the second surface 112 not covered under the dielectric layer 13 is etched away to form a plurality of electrode via holes 17 and 18 and recesses 19.

As shown in FIG. 3E and 3F, the remaining dielectric layers 12 and 13 are then removed. The remaining silicon substrate 11 comprises a plurality of base part 11B and a plurality of cup part 11A. If the dielectric layers 12 and 13 are made of silicon nitride, a heated phosphoric acid can be selected to etch away the remaining dielectric layers 12 and 13. As shown in FIG. 3G, the base parts 11A and the cup parts 11B are then exposed under a high temperature environment with ample oxygen a period of time to form a first insulating layer 21A and 21B covering the base parts 11A and the cup parts 11B. The first insulating layer 21A and 21B is made of silicon dioxide in this embodiment, which has good adherence with silicon and meets the dielectric property requirement.

The chemical reaction function describing the oxidation reaction of silicon under oxygen or water vapor is shown as follows:
Dry oxidation:

   Si (solid) + 02 (gas) -> SiO2 (solid).
Wet oxidation:

   Si (solid) + 2H2O (gas) -> SiO2 (solid) + 2H2 (gas).

In this embodiment, the first insulating layer 21A and 21B is hot oxide generated from a wet oxidation reaction, wherein the reaction temperature is between 900 and 1100 degrees Centigrade. Due to the short reaction time, the thickness of the first insulating layer 21A and 21B is between 30 and 10,000 angstroms.

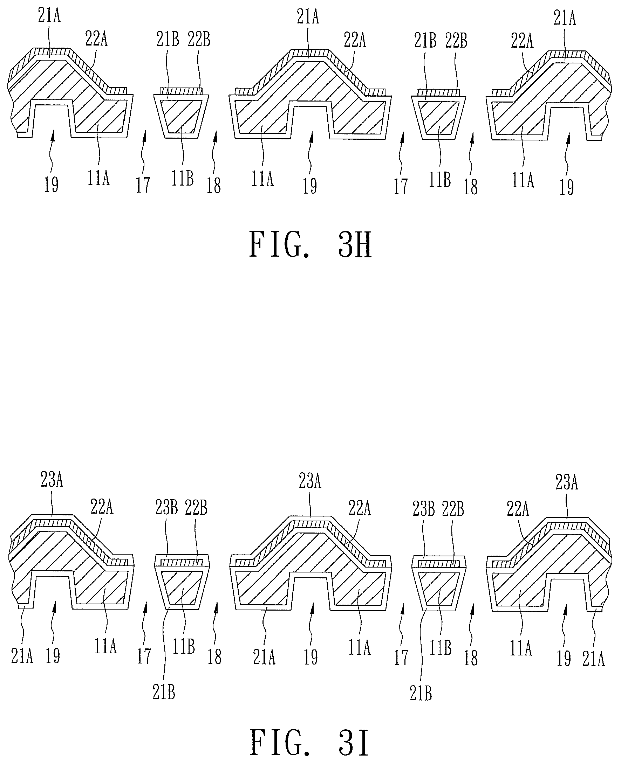

As shown in FIGs. 3H-3I, the first insulating layer 21A and 21B is then covered by a reflective layer 22A and 22B, which can be accomplished by deposition process with physical vapor deposition (PVD) technique. As shown in FIG. 3I, the reflective layer 22A and 22B is then covered by a second insulating layer 23A and 23B, which is a passivation layer generated by PECVD technique. The main purpose of the second insulating layer 23A and 23B, which may be made of silicon dioxide, silicon nitride or silicon oxynitride, is to protect the metal in the reflective layer 22A and 22B from oxidation.

Silicon oxynitride has a similar property with silicon dioxide and silicon nitride. Silicon oxynitride has a smoother stress than silicon nitride, and has better impermeability to water and impurity than silicon dioxide. Therefore, silicon oxynitride is often used as the material for protection layer. Although silicon oxynitride can also deposit under a high temperature environment (> 850 degrees Centigrade) with low pressure chemical vapor deposition (LPCVD) technique, to prevent the metal layer of the silicon substrate from being polluted, it is required that the reaction temperature of the silicon oxynitride, which serves as a protection layer, is not higher than 400 degrees Centigrade. Therefore, the deposition process of the silicon oxynitride nowadays is accomplished by PECVD technique.

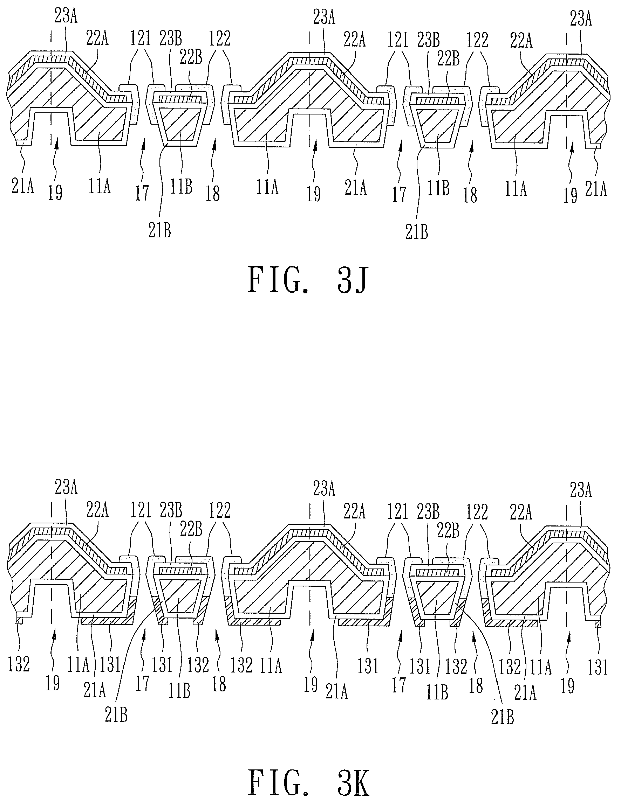

As shown in FIGs. 3J-3K, a conductive layer 121 and 122 is then formed on the surface of the second insulating layer 23A and 23B and extended to the surface of the first insulating layer 21A and 21B. The conductive layer 121 and 122 is made of a solderable material, wherein the material thereof is selected according to the following packaging process and may be silver (Ag), nickel/gold (Ni/Au), titanium/gold (Ti/Au), titanium/nickel/gold (Ti/Ni/Au), titanium/copper/nickel/gold (Ti/Cu/Ni/Au), titanium/tungsten/ copper/nickel/gold (TiW/Cu/Ni/Au) or chromium/ copper/nickel/ gold (Cr/ Cu/Ni/Au). The pattern transfer of the conductive layer 121 and 122 can be accomplished by photolithography process (i.e. the pattern is transferred by etching) or lift-off process. The formation of the conductive layer 121 and 122 can be accomplished by electroplating, evaporating or chemical plating techniques.

The main purpose of the reflective layer 22A and 22B is to increase the brightness of the LED device. The material of the reflective layer 22A and 22B can be the same as that of the conductive layer 121 and 122, such as aluminum/nickel/gold (Al/Ni/Au), or it may be different from that of the conductive layer 121 and 122, such as aluminum (Al), silver (Ag), gold (Au), tin (Sn), copper (Cu) or platinum (Pt) according to different requirement of wavelength. The thickness of the reflective layer 22A and 22B is between 300 and 20,000 angstroms.

As shown in FIG. 3K, backend electrodes 131 and 132 are then disposed on the lower part of the first insulating layer 21A and 21B, wherein the electrode 131 is electrically connected to the conductive layer 121, and the electrode 132 is electrically connected to the conductive layer 122. The electrodes 131 and 132 can be made of solderable material or any material with good conductivity such as gold (Au), nickel/gold (Ni/Au), titanium/gold (Ti/Au), titanium/nickel/ gold (Ti/Ni/Au), titanium/copper/nickel/gold (Ti/Cu/Ni/Au), titanium/tungsten/copper/nickel/gold (TiW/Cu/Ni/Au) or chromium/copper/nickel/gold (Cr/ Cu/Ni/Au). The pattern transfer of the electrodes 131 and 132 can be accomplished by photolithography process (i.e. the pattern is transferred by etching) or lift-off process. The formation of the conductive electrodes 131 and 132 can be accomplished by electroplating, evaporating or chemical plating techniques.

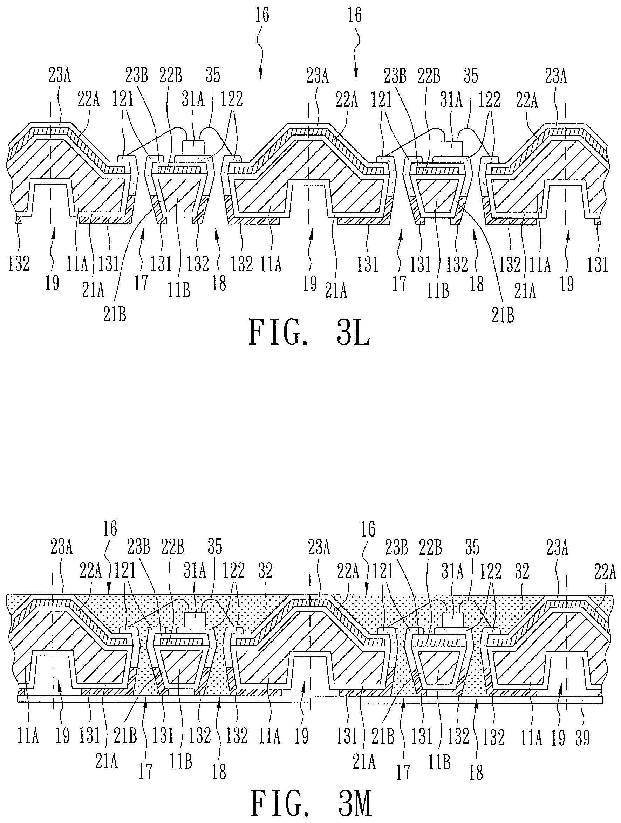

As shown in FIG. 3L, a plurality of photo semiconductor dies 31A is then fixed in the reflective openings 16 of the conductive layer 122 and electrically connected to the conductive layer 121 and 122 via wire bonding technique, i.e., the plurality of photo semiconductor dies 31A is electrically connected to the conductive layer 121 and 122 by metal wires 35.

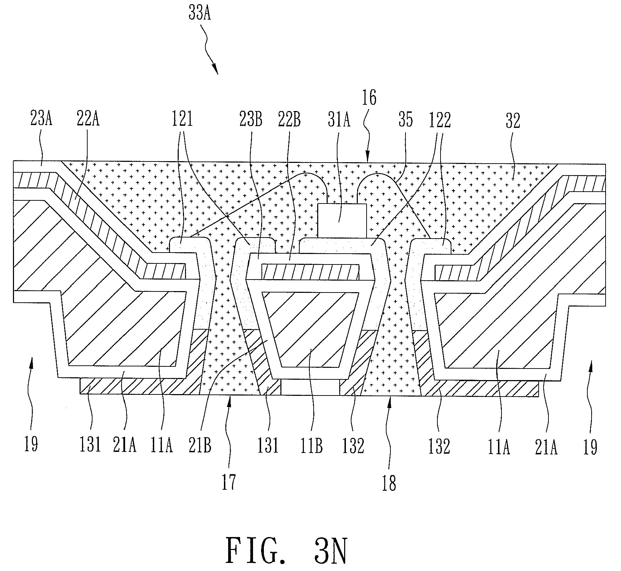

As shown in FIGs. 3M-3N, an encapsulating layer 32 is then formed inside the reflective openings 16 and the electrode via holes 17 and 18 after sealing the electrode via holes 17 and 18 by a tape adhesive 39. After the encapsulating layer 32 is solidified, the tape adhesive 39 is then removed. Other than the tape adhesive 39, there are other encapsulating sealing materials which can be used to prevent the encapsulating layer 32 leaking from the electrode via holes 17, such as thin plate material or mold. Finally, as shown in FIG. 3N, the base part 11B is cut out to form a single LED device 33A. There is at least one recess 19 at each side of the LED device 33A, which is also at the external lateral side of the electrode via holes 17 and 18. When the LED device 33A is to be soldered onto a printed circuit board, the recesses 19 covered by the first insulating layer 21A can prevent the solder from leaking and flowing to the lateral surface of the cup part 11A (silicon substrate), which may cause short circuit. That is, the recesses 19 can contain the leakage of the solder such that the solder will not flow to the lateral surface of the cup part 11A, which is not covered by the insulating layer 21A. When a low resistivity silicon substrate is used for the cup part 11A and the base part 11B, the short circuit problem of the LED device 33A caused by solder leakage is particularly serious. In this embodiment, this problem is solved completely.

Referring to FIG. 1, it can be seen that there is still a part of silicon substrate exposed outside the semi-through holes 86. Therefore, the leakage of the solder will not be fully contained in the semi-through holes 86. Instead, the solder will flow to the part of the silicon substrate not covered by the insulating layer and cause short circuit. In this embodiment, on the other hand, the recesses 19 can contain the leakage of the solder such that the solder will not flow to the lateral surface of the cup part 11A. In addition, the structure of the prior art shown in FIG. 1 and that of this embodiment are different in many ways, which demonstrates the patentability of the present invention.

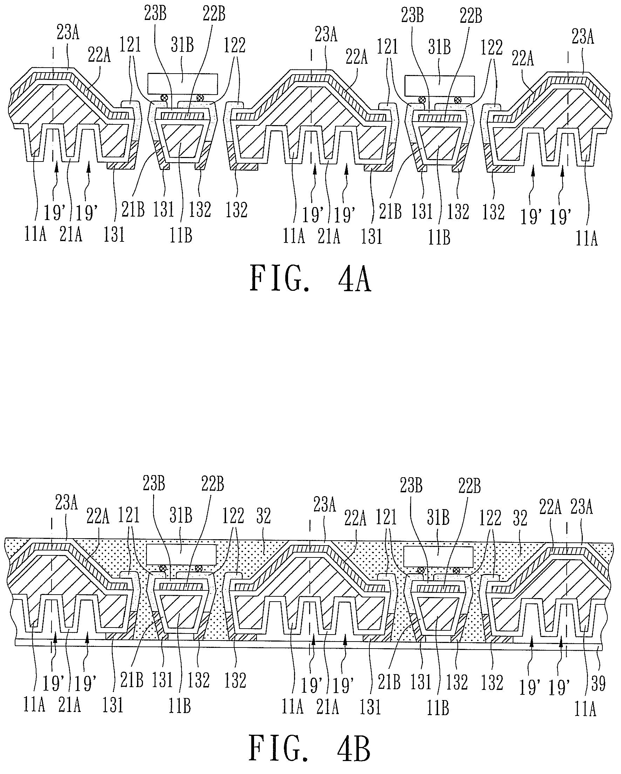

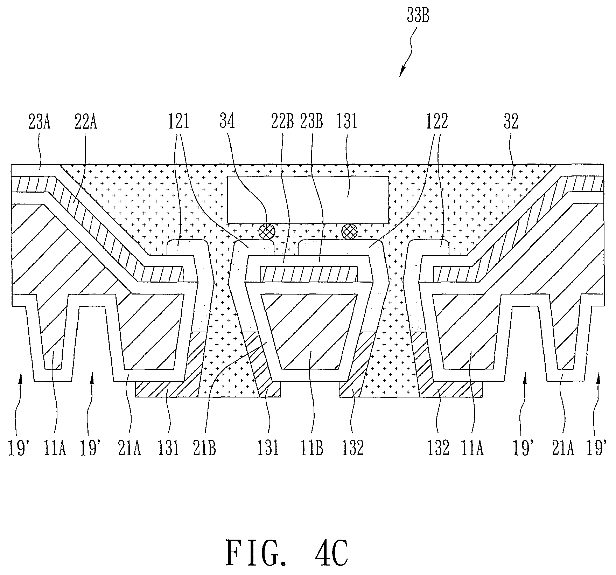

Besides wire bonding, the die 31B can also be fixed and electrically connected to the conductive layer 121 and 122 by flip-flop technique, as shown in FIG. 4A. It can be seen that there is a plurality of recesses 19' located outside the electrode via holes 17 and 18. As shown in FIG. 4B, the electrode via holes 17 and 18 are then sealed by the tape adhesive 39, and the encapsulating layer 32 is formed inside the reflective openings 16 and the electrode via holes 17 and 18. After the encapsulating layer 32 is solidified, the tape adhesive 39 is then removed. Finally, as shown in FIG. 4C, the base part 11B is cut out to form a single LED device 33B, wherein the die 31B is electrically connected to the conductive layer 121 and 122 via bumps 34.

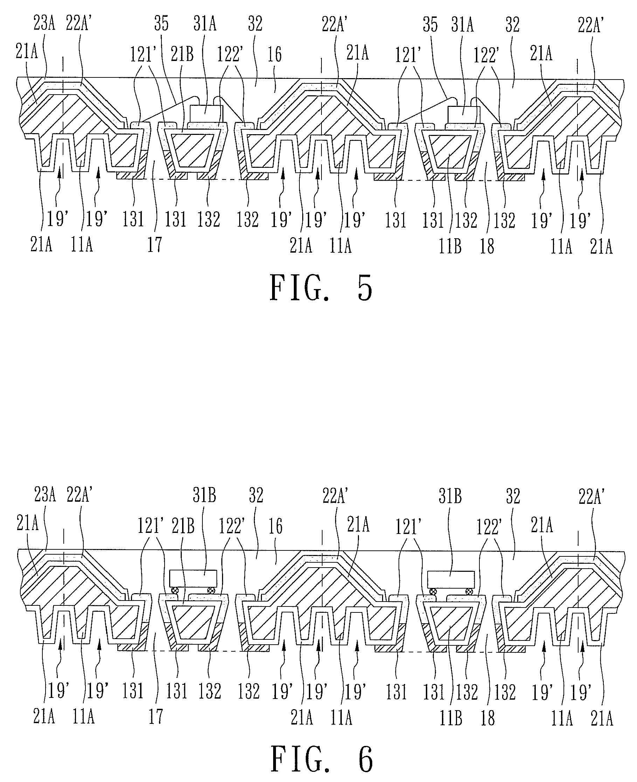

The conductive layer 121 and 122 and the reflective layer 22A and 22B are deposited in different steps. However, as shown in FIG. 5 and 6, those layers can also be formed in one deposition process. FIG. 5 shows the package structure with wire bonding technique. FIG. 6 shows the package structure with flip-flop technique. The conductive layer 121' and 122' and the reflective layer 22A' are formed in one deposition process. That is, they are made of the same material.

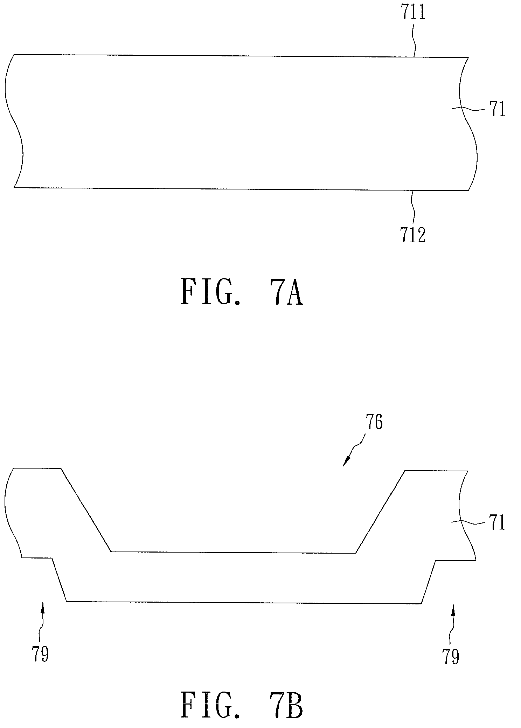

FIGs. 7A to 7I show the flow chart of another embodiment of the manufacturing method for LED devices of the present invention. As shown in FIG. 7A, a silicon substrate 71 is provided, which comprises a first surface 711 and a second surface 712, wherein the first surface 711 is the upper surface and the second surface 712 is the lower surface. The silicon substrate 71 can be a 5-inch, 6-inch, 8-inch or 12-inch silicon wafer. The silicon substrate 11 may adapt a <100> crystal orientation surface. A few important advantages offered by silicon substrate 71 are its great heat dissipation capability and its suitability for well-developed semiconductor process or MEMS process.

As shown in FIG. 7B, a reflective opening 76 is formed on the first surface 711 of the silicon substrate 71 by wet etching technique, and two recesses 79 are formed on each lateral side of the reflective opening 76 on the second surface 712 by wet etching technique as well. The selection of the etchant for the wet etching step can be potassium (KOH). The step in FIG. 7B includes photolithography process, i.e. transferring pattern by etching technique, such as photoresist coating, soft baking, exposure, development, hard baking, silicon substrate etching and photoresist removing. The etching profile of the reflective opening 76 and the recesses 79 is adjustable due to the isotropic of wet etching technique.

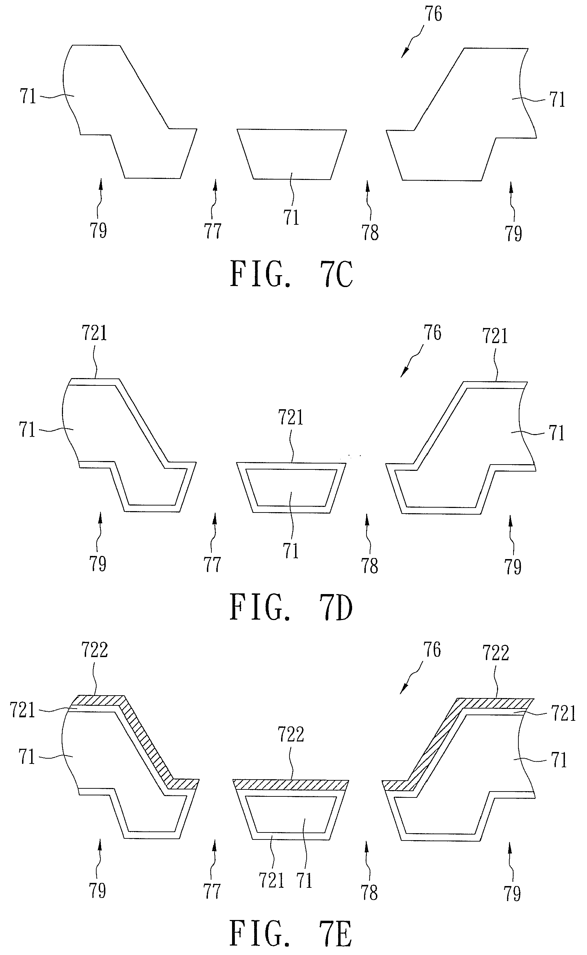

As shown in FIG. 7C, electrode via holes 77 and 78 are then formed on the second surface 712 of the silicon substrate 71 by wet etching technique. The number of the electrode via holes is not limited to two but can be more than two. For example, when more than two light emitting devices are adapted, the number of the electrode via holes 77 and 78 can be four or six. Since the electrode via holes 77 and 78 are formed by wet etching technique, the openings thereof can be made substantially bigger, which makes more room for the subsequent process window. Likewise, the step in FIG. 7C also includes photolithography process.

As shown in FIG. 7D, a silicon oxide layer then covers the silicon substrate 71 to serve as a first insulating layer 721. The formation of the silicon oxide layer can be accomplished by hot oxidation technique or chemical vapor deposition (CVD) technique, wherein the hot oxidation technique is preferred because the silicon oxide formed thereby exhibits a more compact structure. The hot oxidation technique can be either hot or wet hot oxidation technique in this embodiment. The first insulating layer 721 can also be made of silicon nitride.

As shown in FIG. 7E, a reflective layer 722 is then formed inside the reflective opening 76. The reflective layer 722 can be made of silver (Ag), aluminum (Al), gold (Au) or tin (Sn) depending on the wavelength of the light being used. The reflective layer 722 can be formed by electroplating, evaporating or electronbeam epitaxial process. Since the reflective layer 722 is only formed on the first surface 711 of the silicon substrate 71, the process condition is relatively simple. In addition, there can be an optional step to remove the portion of the reflective layer 722 outside the reflective opening 76 after the formation of the reflective layer 722 by another etching technique.

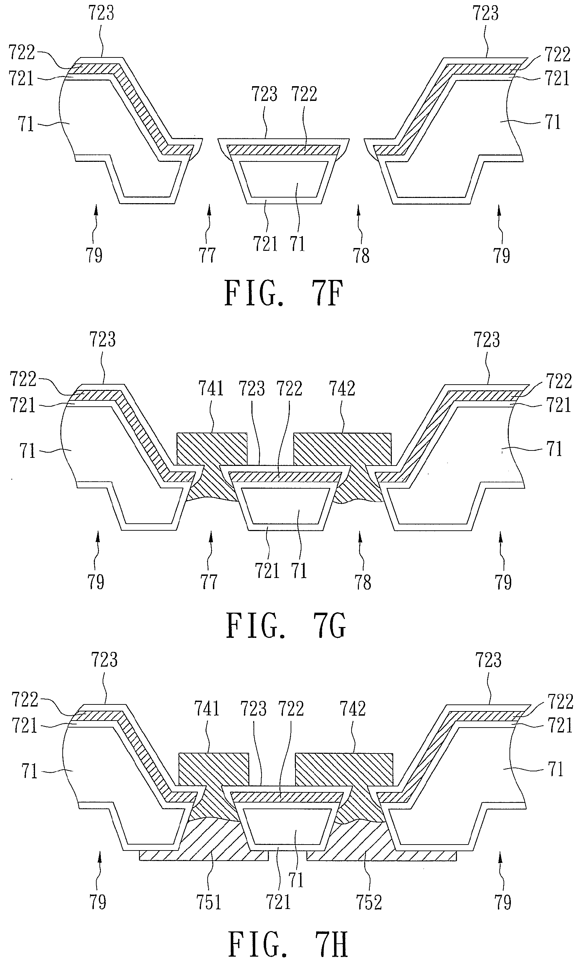

As shown in FIG. 7F, a second insulating layer 723 is then formed to cover the reflective layer 722. The second insulating layer 723 can be made of silicon oxide or silicon nitride and formed by PVD technique, wherein silicon oxide can be formed by PECVD technique and silicon nitride can be formed by LPCVD technique. The thickness of the second insulating layer 723 can be adjusted to generate a constructive interference for a specific light. The second insulating layer 723 covers the reflective layer 722 to prevent oxidation, sulfidation or other chemical reaction of the reflective metal, especially for the reflective metal made of aluminum or tin due to the fact that those two metals are prone to oxidation.

As shown in FIG. 7G, a first metal layer is then formed as front-end electrodes 741 and 742. Since the front-end electrodes 741 and 742 are primarily soldered with light emitting device, the material of the front-end electrodes 741 and 742 can be selected as solderable material depending on the packaging process, such as wire bonding or flip-flop packaging process. The front-end electrodes 741 and 742 can be formed by electroplating or evaporating technique. The pattern of the front-end electrodes 741 and 742 can be formed by pattern transfer etching or lift-off process, wherein the lift-off process is similar to the pattern transfer etching process but with different step sequence. The procedure of the lift-off process is described as follows: forming a photoresist layer, exposure, development, forming the metal layer on the photoresist layer, and removing the photoresist layer along with the metal layer on the photoresist layer. In other words, there is no etching step for metal layer in the lift-off process. Either pattern transfer etching process or lift-off process, however, is a more mature and cost-effective process than the traditional laser process.

The front-end electrodes 741 and 742 and the reflective layer 722 are electrically isolated by the second insulating layer 723, which prevents damage to devices caused by power leakage.

As shown in FIG. 7H, a second metal layer is then formed as back-end electrodes 751 and 752. The back-end electrodes 751 and 752 can be made of solderable material or any ordinary electrode materials. The back-end electrodes 751 and 752 are formed in the same way as the front-end electrodes 741 and 742. The pattern transfer of the back-end electrodes 751 and 752, on the other hand, can be accomplished in the same way or different from that of the front-end electrodes 741 and 742. The back-end electrodes 751 and 752 fill up the electrode via holes 77 and 78 and electrically connect with the front-end electrodes 741 and 742.

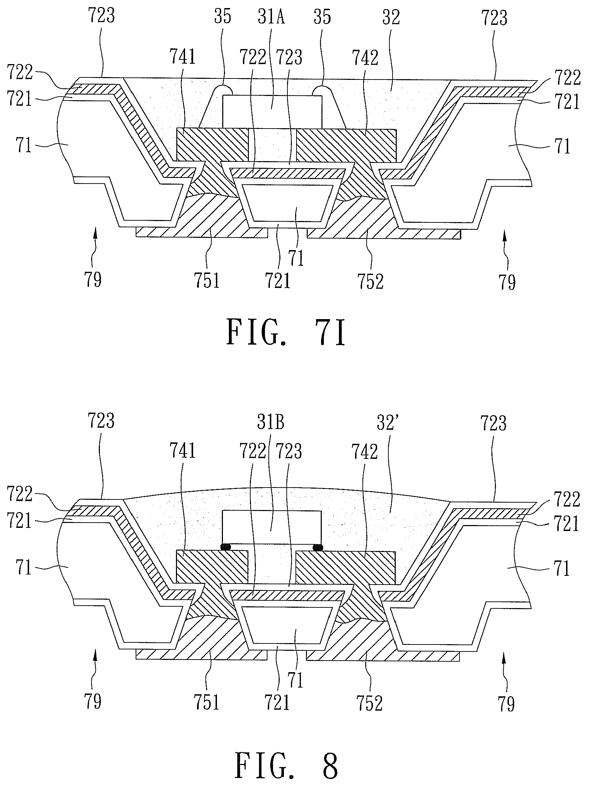

As shown in FIG. 7I, the LED die 31A is then wire bonded and covered by the encapsulating layer 32 made of epoxy. The encapsulating layer 32 can be doped with fluorescent powder such as yttuium aluminium garnet (YAG) or silicate systems. The primary formula of the silicate systems is A2SiO4, wherein A is at least one of strontium (Sr), calcium (Ca), barium (Ba), magnesium (Mg), zinc (Zn) or cadmium (Cd). The filling of the encapsulating layer 32 can be accomplished by transfer molding technique or glob injecting technique.

As shown in FIG. 8, the LED die 31B is flip chip mounted and covered by epoxy. The encapsulating layer 32 can be doped with fluorescent powder such as yttuium aluminium garnet (YAG) or silicate systems. The filling of the encapsulating layer 32 can be accomplished by transfer molding technique or glob injecting technique.

In summary there is disclosed a package structure for LED devices comprises a silicon substrate, a first insulating layer, a reflective layer, a second insulating layer, a first conductive layer, a second conductive layer and a die. The silicon substrate has a first surface and a second surface, wherein the first surface is opposed to the second surface. The first surface has a reflective opening, and the second surface has at least two electrode via holes connected to the reflective opening and a recess disposed outside the electrode via holes. The first insulating layer overlays the first surface, the second surface and the recesses. The reflective layer is disposed on the reflective opening. The second insulating layer is disposed on the reflective layer. The first conductive layer is disposed on the surface of the second insulating layer. The second conductive layer is disposed on the surface of the second surface and inside the electrode via holes. The die is fixed inside the reflective opening and electrically connected to the first conductive layer.

The above-described embodiments of the present invention are intended to be illustrative only. Numerous alternative embodiments may be devised by persons skilled in the art without departing from the scope of the following claims.

## Claims

1. A package structure for LED devices (31A, 31B), comprising:
a monolithic silicon substrate (11, 71) having a first surface (111, 711) and a second surface (112, 712) opposite to said first surface (111, 711), and lateral surfaces connecting said first surface (111, 711) and second surface (112, 712), wherein the first surface (111, 711) has a reflective opening (16, 76), the second surface (112, 712) has a plurality of electrode via holes (17, 18, 77, 78) connected to the reflective opening (16, 76), and at least one recess (19, 79) in the second surface (112, 712);
a first insulating layer (21A, 21B, 721) overlaid on the first surface (111, 711), the second surface (112, 712) and the at least one recess (19, 79);
a reflective layer (22A, 22B, 722) disposed on the reflective opening (16, 76);
a second insulating layer (23A, 23B, 723) disposed on the reflective layer (22A, 22B, 722);
a first conductive layer (121, 122, 741, 742) disposed on the surface of the second insulating layer (23A, 23B, 723) and inside the electrode via holes (17, 18, 77, 78);
a second conductive layer (131, 132, 751, 752) disposed on the second surface (112, 712) and inside the electrode via holes (17, 18, 77, 78), the second conductive layer (131, 132, 751, 752) being in contact with the first conductive layer (121, 122, 741, 742); and
an LED die (31A, 31B) fixed inside the reflective opening (16, 76) and electrically connected to the first conductive layer (121, 122, 741, 742),
wherein the electrode via holes penetrate through the silicon substrate to reach the reflective opening, the at least one recess (19, 79) is located at an external lateral side of the silicon substrate (11, 71) with respect to the electrode via holes (17, 18, 77, 78), and the second conductive layer (131, 132, 751, 752) is located outside the at least one recess (19, 79), at least one recess (19, 79) formed by removing a lateral portion of the second surface (112, 712) to form a stepped second surface extending to a lateral surface, the at least one recess (19, 79) being for containing solder and preventing the solder from flowing to lateral surfaces of the silicon substrate (11, 71).

2. The package structure of claim 1, wherein the first insulating layer (21A, 21B, 721) is made of silicon oxide, the second insulating layer is made of silicon dioxide, silicon nitride or silicon oxynitride, the reflective layer (22A, 22B, 722) is made of aluminum (Al), silver (Ag), gold (Au), tin (Sn) (Ti), copper (Cu) or platinum (Pt), and the first conductive layer (121, 122, 741, 742) and the second conductive layer (131, 132, 751, 752) are made of silver (Ag), nickel/gold (Ni/Au), titanium/gold (Ti/Au), titanium/nickel/gold (Ti/Ni/Au), titanium/copper/nickel/gold (Ti/Cu/Ni/Au), titanium/tungsten/copper/nickel/gold (TiW/Cu/Ni/Au) or chromium/ copper/nickel/gold (Cr/ Cu/Ni/Au).

3. The package structure of claim 1 or 2, wherein the thickness of the reflective layer (22A, 22B, 722) is between 30 nm (300 angstroms) and 2,000 nm (20,000 angstroms).

4. The package structure of one of the preceding claims, wherein the first conductive layer (121, 122, 741, 742) is extended to and connected with the second conductive layer (131, 132, 751, 752).

5. The package structure of one of the preceding claims, wherein the first conductive layer (121, 122, 741, 742) and the second conductive layer (131, 132, 751, 752) are made of a solderable material.

6. The package structure of one of the preceding claims, which further comprises an encapsulating layer (32, 32') filled in the reflective opening.

7. The package structure of one of the preceding claims, wherein the LED die (31A) is
electrically connected to the first conductive layer (121, 122, 741, 742) via a plurality of bumps, or the LED die is electrically connected to the first conductive layer via a plurality of metal wires (35).

8. A fabrication method of a package structure for LED devices (31A), comprising the steps of:
providing a monolithic silicon substrate (11, 71) having a first surface (111, 711) and a second surface (112, 712) opposite to said first surface (111, 711), and lateral surfaces connecting said first surface (111, 711) and second surface (112, 712); etching said a first surface (111, 711) of the silicon substrate to form a reflective opening (16, 76); etching said second surface (112, 712) of the silicon substrate (11, 71) to form two electrode via holes (17, 18, 77, 78) and a plurality of recesses (19, 79) therein, wherein the two electrode via holes (17, 18, 77, 78) penetrate the silicon substrate (11, 71) and reach the reflective opening (16, 76) and the recesses (19, 79) are located at external lateral sides of the silicon substrate (11, 71) with respect to the electrode via holes (17, 18, 77, 78), the recesses (19, 79) each being formed by removing a lateral portion of the second surface (112, 712) to form a stepped second surface extending to a lateral surface, the recesses (19, 79) being for containing solder and preventing the solder from flowing to lateral surfaces of the silicon substrate (11, 71);
forming a first insulating layer (21A, 21B, 721) overlaying the reflective opening (16, 76), the plurality of electrode via holes (17, 18, 77, 78) and the recesses (19, 79);
forming a reflective layer (22A, 22B, 722) on the reflective opening (16, 76); forming a second insulating layer (23A, 23B, 723) on the reflective layer (22A, 22B, 722);
forming a first conductive layer (121, 122, 741, 742) on the surface of the second insulating layer (23A, 23B, 723) and inside the two electrode via holes (17, 18, 77, 78), wherein the first conductive layer (121, 122, 741, 742) serves as two electrode pads and is electrically isolated from the reflective layer (22A, 22B, 722);
forming a second conductive layer (131, 132, 751, 752) on the second surface (112, 712) and inside the two electrode via holes (17, 18, 77, 78), the second conductive layer (131, 132, 751, 752) being in contact with the first conductive layer (121, 122, 741, 742), wherein the second conductive layer (131, 132, 751, 752) is located outside the recesses (19, 79);
fixing an LED die (31A) inside the reflective opening (16, 76) and electrically connecting the LED die (31A) to the first conductive layer (121, 122, 741, 742).

9. The method of claim 8, wherein the first insulating layer (21A, 21B, 721) is a silicon oxide formed by a hot oxidation process, and the second insulating layer (23A, 23B, 723) is made of silicon oxide formed by physical vapor deposition (PVD) technique.

10. The method of claim 8 or 9, wherein the reflective layer (22A, 22B, 722) is made of a silver (Ag), aluminum (Al), gold (Au) or tin (Sn), and the reflective layer (22A, 22B, 722) is formed by electroplating, evaporating or electron beam epitaxial process.

11. The method of one of claims 8 to 10, wherein the first conductive layer (121, 122, 741, 742) and the second conductive layer (131, 132, 751, 752) are made of a solderable material, and the first conductive layer (121, 122, 741, 742) and the second conductive layer (131, 132, 751, 752) are formed by pattern transfer etching or lift-off process.

12. The method of one of claims 8 to 11, wherein the step of etching the second surface (112, 712) is to form four electrode via holes (17, 18, 77, 78), which penetrate the silicon substrate (11, 71) and reach the reflective opening (16, 76).

13. The method of claim 12, wherein the first conductive layer (121, 122, 741, 742) serves as four electrode pads, and the second conductive layer (131, 132, 751, 752) is disposed inside the four electrode via holes (17, 18, 77, 78) and electrically connected with the first conductive layer (121, 122, 741, 742).

## Patentansprüche

1. Verpackungsstruktur für LED-Vorrichtungen (31A, 31B), umfassend:
Ein monolithisches Silikonsubstrat (11, 17) mit einer ersten Oberfläche (111, 711) und einer zweiten Oberfläche (112, 712) gegenüber der genannten ersten Oberfläche (111, 711) und lateralen Oberflächen, die die genannte erste Oberfläche (111, 711) und die zweite Oberfläche (112, 712) anschließen, wobei die erste Oberfläche (111, 711) eine reflektierende Öffnung (16, 76) hat, die zweite Oberfläche (112, 712) eine Vielzahl von Elektrodenbohrungen (17, 18, 77, 78), die an die reflektierende Öffnung (16, 76) angeschlossen sind und wenigs-tens eine Vertiefung (19, 79) in der zweiten Oberfläche (112, 712) hat;
eine erste Isolationsschicht (21A, 21B, 721), die auf der ersten Oberfläche (111, 711), der zweiten Oberfläche (112, 712) und der wenigstens einen Vertiefung (19, 79) überlagert ist;
eine reflektierende Schicht (22A, 22B, 722), die auf der reflektierenden Öffnung (16, 76) angeordnet ist;
eine zweite Isolationsschicht (23A, 23B, 723), die auf der reflektierenden Schicht (22A, 22B, 722) angeordnet ist;
eine erste leitende Schicht (121, 122, 741, 742), die auf der Oberfläche der zweiten Isolationsschicht (23A, 23B, 723) und innerhalb der Elektrodenbohrungen (17, 18, 77, 78) ange-ordnet ist;
eine zweite leitende Schicht (131, 132, 751, 752), die auf der zweiten Oberfläche (112, 712) und innerhalb der Elektrodenbohrungen (17, 18, 77, 78) angeordnet ist, wobei die zweite leitende Schicht (131, 132, 751, 752) mit der ersten leitenden Schicht (121, 122, 741, 742) in Kontakt ist; und
eine LED-Pressform (31A, 31B), die innerhalb der reflektierenden Öffnung (16, 76) befestigt und elektrisch an die erste leitende Schicht (121, 122, 741, 742) angeschossen ist,
wobei sie **dadurch gekennzeichnet ist, dass** die Elektrodenbohrungen durch das Silikonsub-strat hindurchtreten, um die reflektierende Öffnung zu erreichen, die wenigstens eine Vertiefung (19, 79) sich in einer externen lateralen Seite des Silikonsubstrats (11, 71) in Bezug auf die Elektrodenbohrungen (17, 18, 77, 78) befindet und die zweite leitende Schicht (131, 132, 751, 752) sich außerhalb der wenigstens einen Vertiefung (19, 79) befindet, wenigstens eine Vertiefung (19, 79) durch Entfernen eines lateralen Abschnitts der zweiten Oberfläche (112, 712) gebildet ist, um eine abgestufte zweite Oberfläche zu bilden, die sich zu der lateralen Oberfläche erstreckt, wobei die wenigstens eine Vertiefung (19, 79) zum Enthalten von Lötmaterial und dafür vorgesehen ist, das Lötmaterial daran zu hindern, zur lateralen Oberfläche des Silikonsubstrats (11, 71) zu fließen.

2. Verpackungsstruktur gemäß Anspruch 1, bei der die erste Isolationsschicht (21A, 21B, 721) aus Silikonoxid hergestellt ist, die zweite Isolationsschicht aus Silikondioxid, Silikonnitrid oder Silikonoxynitrid hergestellt ist, die reflektierende Schicht (22A, 22B, 722) aus Aluminium (Al), Silber (Ag), Gold (Au), Zinn (Sn) (Ti), Kupfer (Cu) oder Platin (Pt) hergestellt ist und die erste leitende Schicht (121, 122, 741, 742) und die zweite leitende Schicht (131, 132, 751, 752) aus Silber (Ag), Nickel / Gold (Ni/Au), Titan / Gold (Ti/Au), Titan / Nickel / Gold (Ti/Ni/Au), Titan / Kupfer / Nickel / Gold (Ti/Cu/Ni/Au), Titan / Wolfram / Kupfer / Nickel / Gold (TiW/Cu/Ni/Au) oder Chrom / Kupfer / Nickel/Gold (Cr/Cu/Ni/Au) hergestellt ist.

3. Verpackungsstruktur gemäß Anspruch 1 oder 2, bei dem die Dicke der reflektierenden Schicht (22A, 22B, 722) zwischen 30 nm (300 Angström) und 2.000 nm (20.000 Angström) liegt.

4. Verpackungsstruktur gemäß einem der voranstehenden Ansprüche, in der die erste leitende Schicht (121, 122, 741, 742) sich auf die zweite leitende Schicht (131, 132, 751, 752) erstreckt und an sie angeschlossen ist.

5. Verpackungsstruktur gemäß einem der voranstehenden Ansprüche, in der die erste leitende Schicht (121, 122, 741, 742) und die zweite leitende Schicht (131, 132, 751, 752) aus lötbarem Material hergestellt sind.

6. Verpackungsstruktur gemäß einem der voranstehenden Ansprüche, die weiterhin eine Verkapselungsschicht (32, 32') umfasst, die in der reflektierenden Öffnung eingepasst ist.

7. Verpackungsstruktur gemäß einem der voranstehenden Ansprüche, in der die LED-Pressform (31A) elektrisch an die erste leitende Schicht (121, 122, 741, 742) über eine Vielzahl von Höckern angeschlossen ist oder die LED-Pressform elektrisch an die erste leitende Schicht über eine Vielzahl von Metalldrähten (35) angeschlossen ist.

8. Herstellungsverfahren einer Verpackungsstruktur für LED-Vorrichtungen (31A), umfassend die Stufen:
Bereitstellen eines monolithischen Substrats (11, 71) mit einer ersten Oberfläche (111, 711) und einer zweiten Oberfläche (112, 712) gegenüber der genannten ersten Oberfläche (111, 711) und lateralen Oberflächen, die die genannte erste Oberfläche (111, 711) und die zweite Oberfläche (112, 712) anschließen;
Ätzen der genannten einen ersten Oberfläche (111, 711) des Silikonsubstrats, um eine reflektierende Öffnung (16, 76) zu bilden;
Ätzen der genannten einen zweiten Oberfläche (112, 712) des Silikonsubstrats (11, 71), um zwei Elektrodenbohrungen (17, 18, 77, 78) und eine Vielzahl von Vertiefungen (19, 79) darin zu bilden,
wobei die zwei Elektrodenbohrungen (17, 18, 77, 78) in das Silikonsubstrat (11, 71) eindringen und die reflektierende Öffnung (16, 76) erreichen und die Vertiefungen (19, 79) sich an externen lateralen Seiten des Silikonsubstrats (11, 71) in Bezug auf die Elektrodenbohrungen (17,18, 77, 78) befinden, wobei die zwei Elektrodenbohrungen (17, 18, 77, 78) in das Silikonsubstrat (11, 71) eindringen und die reflektierende Öffnung (16, 76) erreichen, die erste Oberfläche (111, 711) der zweiten Oberfläche (112, 712) gegenüber liegt und das Silikonsub-strat laterale Oberflächen hat, die die ersten und zweiten Oberflächen anschließen und die Vertiefungen (19, 79) an externen lateralen Seiten der Elektrodenbohrungen (17, 18, 77, 78) angeordnet sind, wobei die Vertiefungen (19, 79) jeweils durch Entfernen eines lateralen Abschnitts der zweiten Oberfläche (112, 712) gebildet sind, um eine abgestufte zweite Oberfläche zu bilden, die sich zu einer lateralen Oberfläche erstreckt, wobei die Vertiefungen (19, 79) ausgebildet sind, um Lötmaterial zu enthalten und das Lötmaterial daran zu hindern, zu den lateralen Oberflächen des Silikonsubstrats (11, 71) zu fließen;
wobei eine erste Isolationsschicht (21A, 21B, 721) gebildet wird, die die reflektierende Oberfläche (16, 76), die Vielzahl von Elektrodenbohrungen (17, 18, 77, 78) und die Vertiefungen (19, 79) überdeckt;
wobei eine reflektierende Schicht (22A, 22B, 722) auf der reflektierenden Öffnung (16, 76) gebildet wird;
wobei eine zweite Isolationsschicht (23A, 23B, 723) auf der reflektierenden Schicht (22A, 22B, 722) gebildet wird;
wobei eine erste leitende Schicht (121, 122, 741, 742) auf der Oberfläche der zweiten Isolationsschicht (23A, 23B, 723) und innerhalb der zwei Elektrodenbohrungen (17, 18, 77, 78) gebildet werden, wobei die erste leitende Schicht (121, 122, 741, 742) als zwei Elektrodenplättchen dient und von der reflektierenden Schicht (22A, 22B, 722) elektrisch isoliert ist;
wobei eine zweite leitende Schicht (131, 132, 751, 752) auf der zweiten Oberfläche (112, 712) und innerhalb der zwei Elektrodenbohrungen (17, 18, 77, 78) gebildet werden, wobei die zweite leitende Schicht (131, 132, 751, 752) mit der ersten leitenden Schicht (121, 122, 741, 742) in Kontakt ist, wobei die zweite leitende Schicht (131, 132, 751, 752) sich außerhalb der Vertiefungen (19, 79) befindet;
wobei eine LED-Pressform (31A) innerhalb der reflektierenden Öffnung (16, 76) befestigt wird und die LED-Pressform (31A) an die erste leitende Schicht (121, 122, 741, 742) anschließt.

9. Verfahren gemäß Anspruch 8, bei dem die erste Isolationsschicht (21A, 21B, 721) ein Silikonoxid ist, das durch einen Heißoxidatonsprozess gebildet wird und die zweite Isolationsschicht (23A, 23B, 723) aus Silikonoxid hergestellt ist, die durch eine Technik der physischen Dampfablagerung (PVD) gebildet wird.

10. Verfahren gemäß Anspruch 8 oder 9, bei dem die reflektierende Schicht (22A, 22B, 722) aus einem Silber (Ag), Aluminium (Al), Gold (Au) oder Zinn (Sn), (Ti) hergestellt ist und die reflektierende Schicht (22A, 22B, 722) durch Galvanisieren, Verdampfen oder einen epitaktischen Prozess per Elektronenstrahl gebildet wird

11. Verfahren gemäß Anspruch 8 bis 10, bei dem die erste leitende Schicht (121, 122, 741, 742) und die zweite leitende Schicht (131, 132, 751, 752) aus einem lötbaren Material hergestellt sind und die erste leitende Schicht (121, 122, 741, 742) und die zweite leitende Schicht (131, 132, 751, 752) per Musterübertragungsätzen oder einen Abziehprozess gebildet werden.

12. Verfahren gemäß Anspruch 8 bis 11, bei dem die Stufe des Ätzens der zweiten Oberfläche (112, 712) dazu bestimmt ist, vier Elektrodenbohrungen (17, 18, 77, 78) zu bilden, die in das Silikonsubstrat (11, 71) eindringen und die reflektierende Öffnung (16, 76) erreichen.

13. Verfahren gemäß Anspruch 12, bei dem die erste leitende Schicht (121, 122, 741, 742) als vier Elektrodenplättchen dient und die zweite leitende Schicht (131, 132, 751, 752) innerhalb der vier Elektrodenbohrungen (17, 18, 77, 78) angeordnet ist und elektrisch an die erste leitende Schicht (121, 122, 741, 742) angeschlossen ist.

## Revendications

1. Structure de boîtier pour dispositifs à LED (31A, 31B), comprenant :
un substrat de silicium monolithique (11, 71) ayant une première surface (111, 711) et une seconde surface (112, 712) opposée à ladite première surface (111, 711), et des surfaces latérales reliant lesdites première surface (111, 711) et seconde surface (112, 712), dans laquelle la première surface (111, 711) a une ouverture réflexive (16, 76), la seconde surface (112, 712) a une pluralité de trous d'interconnexion d'électrode (17, 18, 77, 78) reliés à l'ouverture réflexive (16, 76), et au moins une partie en retrait (19, 79) dans la seconde surface (112, 712) ;
une première couche isolante (21A, 21B, 721) recouvrant la première surface (111, 711), la seconde surface (112, 712) et l'au moins une partie en retrait (19, 79) ;
une couche réflexive (22A, 22B, 722) disposée sur l'ouverture réflexive (16, 76) ;
une seconde couche isolante (23A, 23B, 723) disposée sur la couche réflexive (22A, 22B, 722) ;
une première couche conductrice (121, 122, 741, 742) disposée sur la surface de la seconde couche isolante (23A, 23B, 723) et à l'intérieur des trous d'interconnexion d'électrode (17, 18, 77, 78) ;
une seconde couche conductrice (131, 132, 751, 752) disposée sur la seconde surface (112, 712) et à l'intérieur des trous d'interconnexion d'électrode (17, 18, 77, 78), la seconde couche conductrice (131, 132, 751, 752) étant en contact avec la première couche conductrice (121, 122, 741, 742) ; et
une puce LED (31A, 31B) fixée à l'intérieur de l'ouverture réflexive (16, 76) et électriquement reliée à la première couche conductrice (121, 122, 741, 742), dans laquelle les trous d'interconnexion d'électrode pénètrent à travers le substrat de silicium pour atteindre l'ouverture réflexive, l'au moins une partie en retrait (19, 79) est située au niveau d'un côté latéral externe du substrat de silicium (11, 71) par rapport aux trous d'interconnexion d'électrode (17, 18, 77, 78), et la seconde couche conductrice (131, 132, 751, 752) est située à l'extérieur de l'au moins une partie en retrait (19, 79), l'au moins une partie en retrait (19, 79) étant formée en enlevant une partie latérale de la seconde surface (112, 712) pour former une seconde surface étagée s'étendant jusqu'à une surface latérale, l'au moins une partie en retrait (19, 79) servant à contenir la soudure et empêcher la soudure de s'écouler vers les surfaces latérales du substrat de silicium (11, 71).

2. Structure de boîtier selon la revendication 1, dans laquelle la première couche isolante (21A, 21B, 721) est faite d'oxyde de silicium, la seconde couche isolante est faite de dioxyde de silicium, de nitrure de silicium ou d'oxynitrure de silicium, la couche réflexive (22A, 22B, 722) est faite d'aluminium (Al), argent (Ag), or (Au), étain (Sn), cuivre (Cu) ou platine (Pt), et la première couche conductrice (121, 122, 741, 742) et la seconde couche conductrice (131, 132, 751, 752) sont faites d'argent (Ag), nickel/or (Ni/Au), titane/or (Ti/Au), titane/nickel/or (Ti/Ni/Au), titane/cuivre/nickel/or (Ti/Cu/Ni/Au), titane/tungstène/cuivre/nickel/or (TiW/Cu/Ni/Au) ou chrome/cuivre/nickel/or (Cr/Cu/Ni/Au).

3. Structure de boîtier selon la revendication 1 ou 2, dans lequel l'épaisseur de la couche réflexive (22A, 22B, 722) est entre 30 nm (300 angströms) et 2 000 nm (20 000 angströms).

4. Structure de boîtier selon l'une quelconque des revendications précédentes, dans laquelle la première couche conductrice (121, 122, 741, 742) est prolongée jusqu'à et reliée à la seconde couche conductrice (131, 132, 751, 752).

5. Structure de boîtier selon l'une quelconque des revendications précédentes, dans laquelle la première couche conductrice (121, 122, 741, 742) et la seconde couche conductrice (131, 132, 751, 752) sont faites d'une matière pouvant être soudée.

6. Structure de boîtier selon l'une quelconque des revendications précédentes, qui comprend en outre une couche d'encapsulation (32, 32') remplie dans l'ouverture réflexive.

7. Structure de boîtier selon l'une quelconque des revendications précédentes, dans laquelle la puce LED (31A) est électriquement reliée à la première couche conductrice (121, 122, 741, 742) via une pluralité de bosses, ou la puce LED est électriquement reliée à la première couche conductrice via une pluralité de fils métalliques (35).

8. Procédé de fabrication d'une structure de boîtier pour des dispositifs LED (31A), comprenant les étapes de :
Fourniture d'un substrat monolithique de silicium (11, 71) ayant une première surface (111, 711) et une seconde surface (112, 712) opposée à ladite première surface (111, 711), et des surfaces latérales reliant lesdites première surface (111, 711) et seconde surface (112, 712) ;
gravure de ladite première surface (111, 711) du substrat de silicium pour former une ouverture réflexive (16, 76) ;
gravure de ladite seconde surface (112, 712) du substrat de silicium (11, 71) pour former deux trous d'interconnexion d'électrode (17, 18, 77, 78) et une pluralité de parties en retrait (19, 79) en son sein, dans lesquels les deux trous d'interconnexion d'électrode (17, 18, 77, 78) pénètrent dans le substrat de silicium (11, 71) et atteignent l'ouverture réflexive (16, 76) et les parties en retrait (19, 79) sont situées au niveau des côtés latéraux externes du substrat de silicium (11, 71) par rapport aux trous d'interconnexion d'électrode (17, 18, 77, 78), les parties en retrait (19, 79) étant chacune formées en enlevant une partie latérale de la seconde surface (112, 712) pour former une seconde surface étagée s'étendant jusqu'à une surface latérale, les parties en retrait (19, 79) servant à contenir la soudure et empêcher la soudure de s'écouler jusqu'aux surfaces latérales du substrat de silicium (11, 71) ;
formation d'une première couche isolante (21A, 21B, 721) recouvrant l'ouverture réflexive (16, 76), la pluralité de trous d'interconnexion d'électrode (17, 18, 77, 78) et les parties en retrait (19, 79) ;
formation d'une couche réflexive (22A, 22B, 722) sur l'ouverture réflexive (16, 76) ;
formation d'une seconde couche isolante (23A, 23B, 723) sur la couche réflexive (22A, 22B, 722) ;
formation d'une première couche conductrice (121, 122, 741, 742) sur la surface de la seconde couche isolante (23A, 23B, 723) et à l'intérieur des deux trous d'interconnexion d'électrode (17, 18, 77, 78), dans laquelle la première couche conductrice (121, 122, 741, 742) sert en tant que deux plages de connexion d'électrode et est électriquement isolée de la couche réflexive (22A, 22B, 722) ;
formation d'une seconde couche conductrice (131, 132, 751, 752) sur la seconde surface (112, 712) et à l'intérieur des deux trous d'interconnexion d'électrode (17, 18, 77, 78), la seconde couche conductrice (131, 132, 751, 752) étant en contact avec la première couche conductrice (121, 122, 741, 742), dans lequel la seconde couche conductrice (131, 132, 751, 752) est située à l'extérieur des parties en retrait (19, 79) ;
fixation d'une puce LED (31A) à l'intérieur de l'ouverture réflexive (16, 76) et reliant électriquement la puce LED (31A) à la première couche conductrice (121, 122, 741, 742).

9. Procédé selon la revendication 8, dans lequel la première couche isolante (21A, 21B, 721) est un oxyde de silicium formé par un processus d'oxydation à chaud, et la seconde couche isolante (23A, 23B, 723) est faite d'oxyde de silicium formé par la technique de dépôt physique en phase vapeur (PVD).

10. Procédé selon la revendication 8 ou 9, dans lequel la couche réflexive (22A, 22B, 722) est faite d'argent (Ag), aluminium (Al), or (Au) ou étain (Sn) et la couche réflexive (22A, 22B, 722) est formée par galvanisation, évaporation ou processus épitaxial par faisceau électronique.

11. Procédé selon l'une des revendications 8 à 10, dans lequel la première couche conductrice (121, 122, 741, 742) et la seconde couche conductrice (131, 132, 751, 752) sont faites d'une matière pouvant être soudée, et la première couche conductrice (121, 122, 741, 742) et la seconde couche conductrice (131, 132, 751, 752) sont formées par gravure à transfert de motif ou processus de décollage.

12. Procédé selon l'une des revendications 8 à 11, dans lequel l'étape de gravure de la seconde surface (112, 712) sert à former quatre trous d'interconnexion d'électrode (17, 18, 77, 78), qui pénètrent dans le substrat de silicium (11, 71) et atteignent l'ouverture réflexive (16, 76).

13. Procédé selon la revendication 12, dans lequel la première couche conductrice (121, 122, 741, 742) sert en tant que quatre plages de connexion d'électrode, et la seconde couche conductrice (131, 132, 751, 752) est disposée à l'intérieur des quatre trous d'interconnexion d'électrode (17, 18, 77, 78) et est électriquement reliée à la première couche conductrice (121, 122, 741, 742).
